# DEMANDE DE BREVET EUROPEEN

(11) **EP 2 090 877 A2**
(43) Date de publication de la demande: **19.08.2009**
(21) Numéro de dépôt: 09152640.0
(22) Date de dépôt: 12.02.2009
(51) Int. Cl.: G01N 13/10, G12B 21/02, G01R 33/09

(54) **Microlevier comprenant un capteur de contrainte par magneto-impedance**

(30) Priorité: 12.02.2008 CH 1982008
(71) Demandeur: CSEM Centre Suisse d'Electronique et de Microtechnique SA - Recherche et Développement, 2002 Neuchâtel (CH)
(72) Inventeur: Cardot, Francis, 2000, Neuchâtel (CH); Polesel-Maris, Jérôme, 91190, Gif-sur-Yvette (FR)
(74) Mandataire: GLN

(57) **Abrégé**

La présente invention concerne notamment un microlevier comprenant un capteur de contrainte.

Ce microlevier comprend une poutre présentant une extrémité destinée à être fixée à un support et une autre extrémité libre, un capteur de contrainte par magnéto-impédance associé à ladite poutre, la déflection de l'extrémité libre de la poutre modifiant la magnéto-impédance du capteur, et des moyens de connexion dudit capteur de contrainte à une source de courant à haute fréquence et à des moyens de détection de la variation de la magnéto-impédance du capteur agencés pour en déduire la déflection de la poutre.

## Description

### Domaine technique

La présente invention concerne un microlevier comprenant une poutre présentant une extrémité destinée à être fixée à un support et une autre extrémité libre. La présente invention concerne également un dispositif de mesure d'une valeur par détection de déflection d'un microlevier soumis à une contrainte.

### Etat de la technique

Les microleviers sont utilisés par exemple dans le domaine de la microscopie par sonde locale, en utilisant un microscope à force atomique (AFM), un microscope à effet tunnel (STM) ou un microscope optique en champ proche (SNOM). Ils sont mis en oeuvre pour visualiser par exemple la topologie de la surface d'un échantillon, la déflection de l'extrémité libre de la poutre étant fonction de l'état de surface de l'échantillon. La méthode classique pour détecter la déflection de l'extrémité de la poutre est de mesurer les oscillations du microlevier en utilisant la réflexion d'un rayon laser. Une telle méthode est largement connue de l'Homme du métier et n'a pas besoin d'être décrite plus en détails. Les inconvénients de cette méthode utilisant des moyens de détection externes au microlevier sont d'une part de nécessiter une calibration manuelle du laser par rapport à la poutre et d'autre part de ne pas être compatible avec une architecture en matrice de microleviers. De plus, il est très délicat de réaliser des mesures par AFM dans un milieu liquide car l'interface air-liquide mal contrôlée provoque des fluctuations dans la mesure optique de la déflection du levier.

Il existe également des méthodes selon lesquelles des capteurs sont mis en oeuvre dans le corps du microlevier. Les avantages de cette technique sont la facilité des réglages et la possibilité de travailler dans des milieux non-transparents. De plus, les systèmes à capteur intégrés résolvent le problème de la limite de diffraction de la méthode à microlevier optique pour détecter le mouvement d'un levier de dimensions inférieures à la moitié de la longueur d'onde de la lumière, c'est-à-dire jusqu'à quelques dizaines de nanomètres, comme cela a été démontré expérimentalement par Mo Li, H. X. Tang and M. L. Roukes , Nature Nanotech. 2, 114 (2007). Les avantages de travailler avec un microlevier très petit (de l'ordre de 100 nm de long) sont d'augmenter le facteur de qualité et la fréquence de résonance, et de diminuer les effets hydrodynamiques visqueux lorsque les mesures sont réalisées en milieu liquide. Les dispositifs de détection intégrés couramment utilisés sont basés sur les effets piézorésistifs (cf. US 5,444,244) ou piézoélectriques. Les mesures de la déflection sont effectuées par détection de la contrainte maximale à la base du microlevier, qui est induite par la déflection de son extrémité libre. Malheureusement, les procédés de microfabrication pour la mise en place de capteurs intégrés étant plus sophistiqués, les coûts de fabrication de tels dispositifs sont supérieurs aux coûts de fabrication des microleviers passifs utilisant des moyens de détection de la déflection externes. Le choix du matériau de la poutre, du silicium dans la plupart des cas, représente également une limitation à l'élaboration de détecteur électrique et à la réalisation des connexions.

On connait également des capteurs permettant une détection de contrainte mécanique basée sur la magnétostriction appelée aussi effet Villari. De tels capteurs sont décrits par exemple dans les demandes de brevets ou brevets US 5,856,617, DE 10 2004 032482 et WO/03/043051.

Dans ces documents, la contrainte mécanique exercée induit une modification de la résistance électrique, qui est alors mesurée pour donner une valeur de déflection de la poutre. La mesure de la résistance se fait à courant continu.

Dans le document WO 99/60330, l'effet de magnétostriction est utilisé pour entrainer l'oscillation du microlevier, sa déflection étant déterminée par un capteur optique externe.

Un but de la présente invention est de proposer un autre type de microlevier simple et économique à fabriquer, et présentant une sensibilité élevée.

Un autre but de la présente invention est de proposer un microlevier pouvant être réalisé dans d'autres matériaux que le silicium, et compatible avec l'utilisation d'une pointe.

Un autre but de la présente invention est de proposer un microlevier pouvant être utilisé seul ou en matrice, en mode contact ou dynamique, dans l'air ou en milieu liquide.

### Divulgation de l'invention

A cet effet, et conformément à la présente invention, il est proposé un microlevier comprenant une poutre présentant une extrémité destinée à être fixée à un support et une autre extrémité libre, un capteur de contrainte par magnéto-impédance associé à ladite poutre, la déflection de l'extrémité libre de la poutre modifiant la magnéto-impédance du capteur, et des moyens de connexion dudit capteur de contrainte à une source de courant à haute fréquence et à des moyens de détection de la variation de la magnéto-impédance du capteur agencés pour en déduire la déflection de la poutre. Selon l'invention, la poutre et le capteur de contrainte sont réalisés dans le même élément de matériau magnétique de manière à former une structure monolithique.

Selon une variante de réalisation, le support peut être intégré au microlevier et réalisé dans le même élément de matériau magnétique que la poutre et le capteur de contrainte de manière à former une structure monolithique.

En fonction des utilisations prévues, la poutre du microlevier peut comprendre, ou non, une pointe pour microscopie par sonde locale, disposée par exemple à proximité de l'extrémité libre de la poutre. D'une manière avantageuse, ladite pointe peut être réalisée dans le même élément de matériau magnétique que la poutre de manière à former une structure monolithique.

La présente invention concerne également un ensemble de microleviers comprenant un support et au moins deux microleviers tels que décrits ci-dessus, une extrémité de la poutre de chacun des microleviers étant fixée audit support, dans lequel le support est réalisé dans le même élément de matériau magnétique que la poutre et le capteur de contrainte, de manière à former une structure monolithique.

La présente invention concerne également un dispositif de mesure d'une valeur par détection de déflection d'un microlevier soumis à une contrainte comprenant:
- un support,
- une source de courant à haute fréquence,
- au moins un microlevier comprenant une poutre, présentant une extrémité destinée à être fixée audit support et une autre extrémité libre, et un capteur de contrainte par magnéto-impédance associé à ladite poutre, la déflection de l'extrémité libre de la poutre modifiant la magnéto-impédance du capteur, des moyens de connexion dudit capteur de contrainte à ladite source de courant, et
- des moyens de détection de la variation de la magnéto-impédance du capteur agencés pour en déduire la déflection de la poutre et pour générer des signaux représentatifs de la valeur mesurée.

De préférence, la poutre et le capteur de contrainte, et éventuellement le support, peuvent être réalisés dans le même élément de matériau magnétique pour obtenir une structure monolithique.

La présente invention concerne également un procédé de fabrication d'un microlevier tel que décrit ci-dessus, comprenant une étape de réalisation d'un moule comprenant au moins un fond en matériau monocristallin permettant une attaque anisotrope selon ses plans cristallins et une étape de formation du microlevier par électrodéposition d'un matériau magnétique doux dans le moule.

La présente invention concerne également l'utilisation d'un microlevier ou d'un ensemble de microleviers, tels que décrits ci-dessus et comprenant une pointe, pour réaliser de l'analyse par sonde locale.

La présente invention concerne également l'utilisation d'un microlevier ou d'un ensemble de microleviers, tels que décrits ci-dessus et ne comprenant pas de pointe, pour la réalisation de détecteurs chimiques, thermiques ou d'humidité.

La présente invention concerne enfin un procédé de mesure d'une valeur par détection de la déflection d'un microlevier soumis à une contrainte, ledit microlevier comprenant une poutre et un capteur de contrainte par magnéto-impédance associé à ladite poutre, en particulier au moyen d'un dispositif tel que décrit ci-dessus, ledit procédé comprenant une étape de mesure de la modification de la magnéto-impédance dudit capteur de contrainte lorsqu'il est soumis à un courant à haute fréquence, consistant plus particulièrement à mesurer la réactance dudit capteur de contrainte. Brève description des dessins

D'autres caractéristiques de la présente invention apparaîtront plus clairement à la lecture de la description qui va suivre, faite en référence aux dessins annexés, dans lequel:
- la figure 1 représente une première variante d'un microlevier utilisé dans l'invention,
- la figure 2 représente une première variante d'un dispositif de mesure selon l'invention,
- la figure 3 représente schématiquement les différentes étapes d'un premier procédé de fabrication d'un microlevier selon l'invention,
- les figures 4a et 4b représentent schématiquement les différentes étapes d'un second procédé de fabrication d'un microlevier selon l'invention,
- les figures 5 à 8 représentent d'autres variantes d'un dispositif de mesure selon l'invention, et
- les figures 9 à 10 représentent deux variantes de circuits utilisés dans la présente invention.

### Mode(s) de réalisation de l'invention

La présente invention concerne tout d'abord un microlevier dont la déflection, lorsqu'il est soumis à une contrainte, est utilisée pour mesurer une valeur représentative de l'état de surface d'un échantillon lorsque le microlevier est utilisé dans les microscopes à sonde de balayage, ou pour indiquer la présence d'un composé chimique lorsque le microlevier est utilisé comme détecteur chimique.

Le microlevier comprend:
- une poutre présentant une extrémité destinée à être fixée à un support et une autre extrémité libre, ladite poutre pouvant comprendre, par exemple à proximité de son extrémité libre, une pointe pour microscopie par sonde locale,
- un capteur de contrainte par magnéto-impédance associé à ladite poutre, la déflection de l'extrémité libre de la poutre modifiant la magnéto-impédance du capteur, et
- des moyens de connexion dudit capteur de contrainte à une source de courant à haute fréquence et à des moyens de détection de la variation de la magnéto-impédance du capteur agencés pour en déduire la déflection de la poutre.

La magnéto-impédance, mise en oeuvre dans la présente invention, utilise un principe totalement différent de la magnétostriction, appelé effet Kelvin. Selon cet effet Kelvin, on crée un effet de peau sur un matériau ferromagnétique en injectant un courant à haute fréquence dans le matériau. Ce courant haute fréquence excite magnétiquement ledit matériau soumis à la contrainte mécanique à mesurer. Cette contrainte mécanique induit une modification de la réactance, mesurée via une modification de la perméabilité magnétique du matériau.

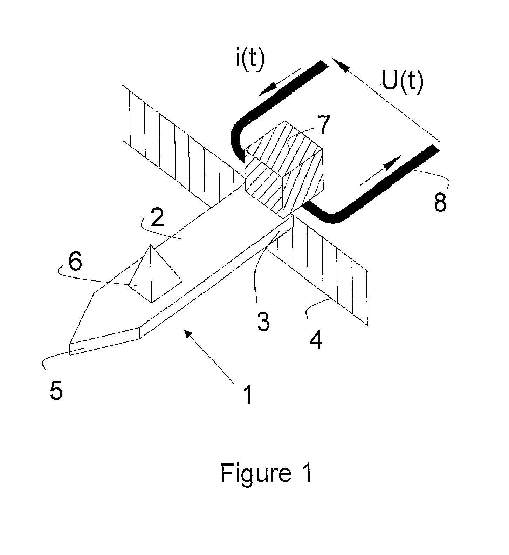

Le capteur de contrainte peut être disposé sensiblement au niveau de l'encastrement de la poutre fixée au support. Selon cette variante représentée par la figure 1, le microlevier 1 comprend une poutre 2 en silicium, de forme générale rectangulaire, dont une extrémité 3 est fixée à un support 4 (à base de silicium ou de polymère) et dont l'autre extrémité 5 est libre. A proximité de l'extrémité libre 5 est disposée une pointe 6 pour microscopie par sonde locale, de type mesure de force atomique (AFM), mesure de courant tunnel (STM) ou mesure de champ évanescent optique (SNOM). De telles pointes sont connues de l'Homme du métier et n'ont pas besoin d'être décrites plus en détails.

Un capteur de contrainte par magnéto-impédance 7 est disposé sensiblement au niveau de l'extrémité 3 de la poutre 5 fixée au support 4. Le capteur 7 est réalisé dans un matériau magnétique doux, tel que le permalloy (NiFe). De plus amples détails sur ce matériau seront décrits ultérieurement.

Le capteur de contrainte par magnéto-impédance 7 est relié à une source de courant alternatif à haute fréquence (non représentée).

Pour relier le capteur de contrainte par magnéto-impédance 7 à la source de courant, il est prévu des électrodes conductrices 8 présentant de faibles propriétés magnétiques et pouvant être facilement réalisées sur un support à base de silicium ou polymère. De telles électrodes 8 sont par exemple en or, argent ou cuivre. Elles peuvent être également utilisées comme guides lors de l'électrodéposition du matériau ferromagnétique au niveau de l'encastrement du levier où la pression mécanique est maximale en cas de déflection à l'extrémité libre de la poutre.

Il est bien évident que la poutre peut présenter d'autres formes, par exemple une forme en U, chaque extrémité des branches du U étant fixée au support. Dans ce cas, un capteur de contrainte par magnéto-impédance est disposé au niveau de l'extrémité de chacune des branches du U où la tension est maximale en cas de déflection à l'extrémité libre de la poutre. Les électrodes sont disposées le long du U. Une géométrie de poutre à double encastrement, c'est-à-dire sans extrémité libre, peut être aussi envisagée avec ou sans pointe. Les points d'encastrement étant fixés sur le support, la pointe sera alors présente sur la zone suspendue du microlevier.

La poutre peut présenter une fente longitudinale dont l'extrémité, du côté de l'extrémité libre de la poutre, est ouverte afin de pouvoir amener un liquide jusqu'à ladite extrémité libre de la poutre, ou par exemple jusqu'à la pointe. L'autre extrémité de la fente peut être ouverte ou fermée. La fente peut s'étendre sur toute ou partie de la longueur de la poutre jusqu'à un réservoir contenant ledit liquide. Une telle poutre peut être réalisée en plaçant dans le moule de fabrication de la poutre un mur permettant de former la fente.

Selon une autre variante, conformément à la présente invention, le capteur de contrainte et la poutre sont réalisés dans le même élément de matériau magnétique doux, de manière à former une structure monolithique.

Selon une autre variante conformément à la présente invention, le support est intégré au microlevier, et le capteur de contrainte, la poutre et ledit support sont réalisés dans le même élément de matériau magnétique, afin d'obtenir une structure monolithique.

Lorsque le microlevier comprend une pointe, ladite pointe peut également être réalisée en matériau magnétique doux de manière à obtenir une structure monolithique. Un tel microlevier monolithique peut être réalisé selon différents procédés.

Un procédé particulièrement préféré selon l'invention pour obtenir une telle structure monolithique comprend une étape de réalisation d'un moule comprenant au moins un fond en matériau monocristallin permettant une attaque anisotrope selon ses plans cristallins et une étape de formation du microlevier par électrodéposition d'un matériau magnétique doux dans le moule. Ce matériau monocristallin présente un comportement conducteur ou semi conducteur permettant qu'un contact électrique puisse être effectué sur ce matériau. Ce matériau sera de préférence du silicium monocristallin.

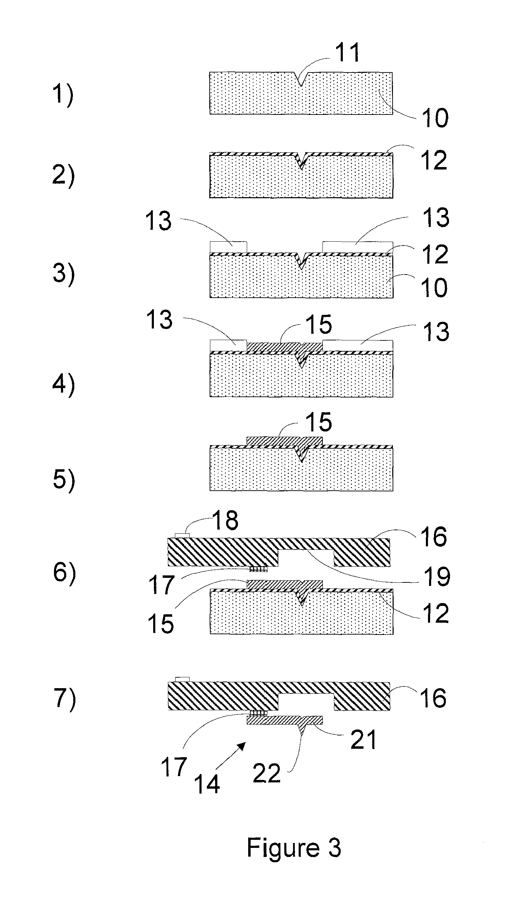

Une première variante de procédé est décrite en référence à la figure 3, et est basée sur l'électrodéposition d'un matériau magnétique doux sur un substrat en silicium en utilisant une résine photosensible comme masque pour réaliser la forme du microlevier. Selon cette variante, la première étape 1) comprend une attaque anisotrope d'un substrat de silicium 10 en utilisant un procédé connu de l'état de la technique (par exemple attaque au KOH) pour créer dans le matériau une pyramide concave 11 correspondant à la forme de la pointe. Afin d'obtenir une pointe très fine, il est possible de provoquer une oxydation ou de déposer du nitrure de silicium.

Lors de la deuxième étape 2), le substrat 10 obtenu est recouvert d'une couche sacrificielle 12 (métal, oxyde, résine photosensible par exemple) et d'une couche conductrice galvanique (métal).

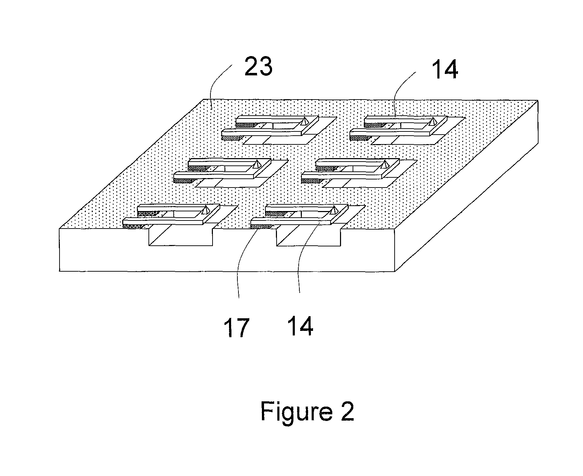

Lors de l'étape 3), un masque 13 utilisant une résine photosensible est créé sur le substrat 10 obtenu, en fonction de la forme et des dimensions de microlevier souhaitées. Le masque peut être tel que le microlevier obtenu présente une forme en U, tel que cela est représenté pour un microlevier 14 de la figure 2.

Lors de l'étape 4), un alliage ferromagnétique 15 du type fer-nickel (permalloy) est électrodéposé, selon des procédés connus, à travers le masque 13, et en étant au contact de la couche conductrice galvanique.

Lors de l'étape 5, le masque en résine photosensible 13 est éliminé. Il est possible de polir la couche d'alliage 15 de manière à ajuster son épaisseur.

L'étape 6 consiste à réaliser un connecteur 16 comprenant des emplacements 17 pour les moyens de connexion électrique et mécanique au microlevier et des emplacements 18 pour les connexions électriques aux moyens électroniques de commande, et en particulier aux moyens de détection de la variation de la magnéto-impédance. Le connecteur 16 comprend également une cavité 19 au-dessus de laquelle sera disposé le microlevier, formant ainsi un espace libre pour sa déflection.

Lors de l'étape 7, l'alliage ferromagnétique 15 est tout d'abord raccordé au connecteur 16 au niveau des emplacements 17 correspondants par thermocompression, soudage, colle conductrice ou film conducteur anisotrope par exemple. Le microlevier 14 est ensuite formé en libérant la poutre 21 et la pointe 22 par dissolution de la couche sacrificielle 12.

On obtient une tête de sonde 23 comprenant un ensemble ou une matrice de microleviers 14, telle que représentée sur la figure 2.

Ce procédé permet de contrôler la longueur et la largeur du microlevier grâce à la précision du procédé photolithographique. L'épaisseur du microlevier est contrôlée par le procédé par électrodéposition et par le polissage subséquent.

Une modification de ce procédé peut consister à ne pas réaliser l'électrodéposition sur une couche sacrificielle 12 mais directement sur le silicium ou sur le silicium recouvert d'un métal oxydé tel que le titane ou le chrome ou un acier inoxydable. Sur de telles surfaces, l'électrodéposition est possible mais l'adhérence du dépôt est faible. Après l'étape 7) de raccordement au connecteur, le microlevier est libéré en séparant mécaniquement le microlevier du substrat en silicium. La séparation est facile du fait de la faible adhérence du dépôt de l'alliage ferromagnétique au substrat de silicium.

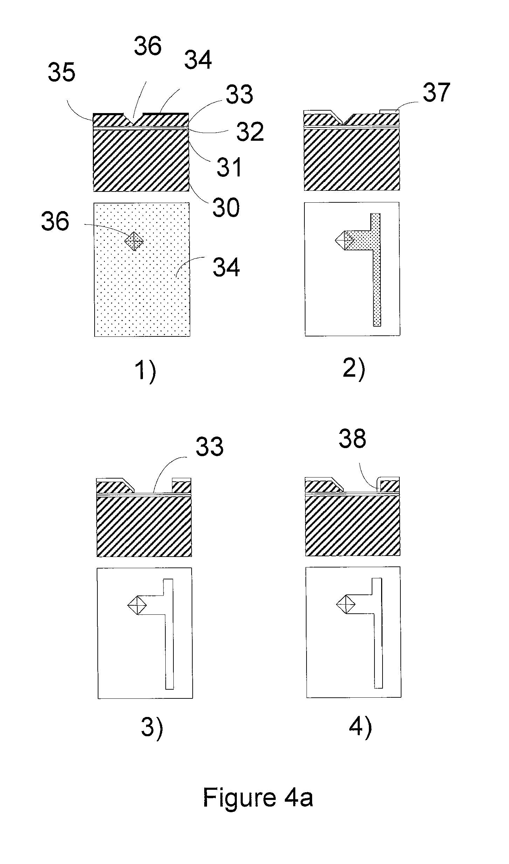

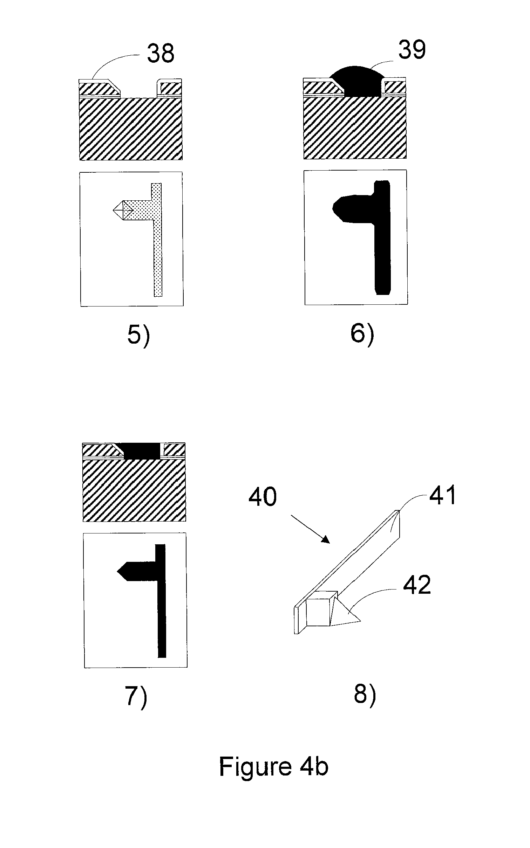

Une seconde variante de procédé est décrite en référence aux figures 4a et 4b, et est basée sur l'électrodéposition d'un matériau magnétique doux dans un moule de formes appropriées réalisé par attaque d'un substrat en silicium. La vue de dessus représente une vue en coupe du substrat et la vue de dessous représente une vue de dessus du substrat.

Selon cette variante, le substrat est une plaque de silicium sur isolant (SOI wafer) constituée d'une première plaque de silicium 30 (handle wafer) assemblée à une deuxième plaque de silicium 35 (device wafer). La plaque de silicium 30 est recouverte d'une couche de nitrure de silicium 31 d'épaisseur comprise entre 50 et 150 nm et d'une couche de polysilicium 32 d'épaisseur comprise entre 50 et 100 nm et oxydée sur une épaisseur de 50 à 200 nm à sa surface supérieure 33.

La première étape 1) comprend la création d'un masque 34, destiné à une attaque chimique humide, par dépôt et définition d'un motif adéquat d'une couche de nitrure de silicium à la surface du substrat 35. Puis on réalise une attaque anisotrope humide du substrat de silicium 35 par un procédé connu de l'état de la technique (par exemple attaque au KOH) pour créer dans le matériau un trou de forme pyramidale 36 correspondant à la forme de la pointe du microlevier. Un procédé alternatif consiste à utiliser un wafer SOI réalisé en utilisant un device wafer présentant une très haute résistivité, comprise entre 5 et 50 kΩ.cm, et à remplacer les couches intermédiaires 31, 32 et 33 par une couche d'oxyde de silicium d'épaisseur comprise entre 50 et 200 nm.

Selon l'étape 2, le masque de nitrure 34 est éliminé et l'on forme une couche d'oxyde thermique de silicium 37 d'épaisseur comprise entre 100 et 200 nm. Le masque d'attaque est réalisé sur la couche d'oxyde, en laissant environ la moitié des parois du trou 36 protégées.

A l'étape 3, le silicium non protégé est attaqué jusqu'à la couche oxydée 33 intermédiaire en utilisant un procédé d'attaque ionique réactive profonde (par exemple un procédé Bosch modifié). On obtient un moule de silicium à parois verticales, à l'exception des parois protégées du trou de forme pyramidale 36.

Selon l'étape 4, on effectue une oxydation thermique, pour recouvrir le moule en silicium d'une couche d'oxyde 38 épaisse, d'une épaisseur comprise entre 400 et 900 nm, à l'exception du fond du moule où la couche de nitrure 31 intermédiaire permet seulement l'oxydation du polysilicium restant, ce qui conduit à l'obtention d'une couche d'oxyde très fine par rapport au reste du moule. Cette étape sera sautée dans le procédé alternatif.

Selon l'étape 5, on effectue une attaque partielle de l'oxyde 38, ce qui élimine la couche fine d'oxyde au fond du moule. Les autres parties du moule restent recouvertes par l'oxyde thermique 38. La couche de nitrure 31 est à son tour attaquée, ce qui permet de faire apparaitre au fond du moule la couche de silicium extrêmement conductrice du wafer 30. Dans le procédé alternatif, on ne réalise que l'attaque de l'oxyde au fond du moule.

Selon l'étape 6, le wafer conducteur est connecté électriquement de manière à pouvoir réaliser l'électrodéposition d'un alliage ferromagnétique 39 du type permalloy (NiFe) dans le moule de silicium.

A l'étape 7, le dépôt d'alliage ferromagnétique 39 est poli jusqu'à obtenir la largeur souhaitée du microlevier.

A l'étape 8, le microlevier 40 est obtenu par séparation du moule en utilisant une attaque chimique humide du silicium et de l'oxyde de silicium. On obtient un microlevier 40 présentant une poutre 41 et une pointe fine 42. Il est possible ensuite de réaliser un traitement ultérieur, tel que érosion chimique ou électrochimique ou dépôt de matériau localisé, de manière à améliorer l'apex de la pointe 42.

Ce procédé permet de mieux contrôler l'épaisseur et la longueur du microlevier grâce à la précision du procédé photolithographique et à la précision du procédé par attaque du silicium.

D'une manière plus générale, et pour l'ensemble des variantes décrites ci-dessus, le matériau magnétique utilisé dans la présente invention pour réaliser soit le capteur de contrainte par magnéto-impédance seul, soit l'ensemble poutre/capteur de contrainte par magnéto-impédance, comprenant éventuellement le support, est de préférence un matériau ferromagnétique possédant des propriétés magnétiques telles que le champ coercitif est inférieur à 2 Oe et que la perméabilité magnétique relative est supérieure à 1000, afin de maximiser l'effet de peau. Ledit matériau peut être un alliage métallique, par exemple un alliage métallique à base de nickel et de fer, la concentration en fer étant comprise entre 10% et 60% en poids par rapport au poids total de l'alliage.

Le matériau magnétique est de préférence déposé par un procédé d'électrodéposition classique, à partir du bain sulfate/chlorure standard. Un tel bain peut contenir par exemple 200g/l de sulfate de nickel hexahydraté, 5 g/l de chlorure de nickel hexahydraté, 25 g/l d'acide borique, 8 g/l de sulfate ferreux heptahydraté et 3 g/l de saccharine. On travaille par exemple à pH = 4 et à une température de 25°C.

Il est préférable de réaliser l'électrodéposition sous champ magnétique externe contrôlé, c'est-à-dire uniforme et bien orienté, afin d'orienter magnétiquement le matériau magnétique doux et d'induire une réponse linéaire du capteur par magnéto-impédance vis-à-vis de la contrainte mécanique appliquée.

Une passivation des fils de connexion du dispositif permet d'utiliser les microleviers selon l'invention en milieu liquide.

On obtient des microleviers de dimensions classiques, présentant une longueur de 100 à 300 µm, une largeur de 15 à 30 µm et une épaisseur de 1 à 2 µm. Les limitations en dimensions sont liées à la résolution minimale atteignable par les techniques de photolithographie pour la microfabrication connue de l'Homme du métier. Des procédés utilisant la croissance épitaxiale des matériaux précités combinée à la structuration par lithographie par faisceau électronique permettent d'envisager de tels leviers avec des dimensions nanométriques comme décrit par par Mo Li, H. X. Tang and M. L. Roukes , Nature Nanotech. 2, 114 (2007). Sur de tels leviers nanométriques, la technique de dépôt dite de « Nanostencil » tel que décrite par Champagne A.R., Couture A.J., Kuemmeth F. et al., Appl. Phys. Lett. 82, 1111 (2003) permet de construire la nanopointe à l'extrémité libre du nanolevier pour les applications d'analyse par sonde locale tel que par exemple l'imagerie ou la spectroscopie de force.

Les procédés selon l'invention permettent de réaliser des microleviers ferromagnétiques présentant des modules de Young et des constantes de rappel très proches de ceux des leviers en silicium. Ces procédés sont également compatibles avec la fabrication d'une pointe fine à l'extrémité libre du levier. Ils permettent une fabrication simple et économique du microlevier.

La présente invention concerne également des dispositifs de mesure d'une valeur par détection de déflection réalisés à partir des microleviers basés sur le principe de la magnéto-impédance.

Ces dispositifs comprennent:
- un support sur lequel est fixé au moins un microlevier,
- une source de courant à haute fréquence,
- au moins un microlevier tel que décrit-ci-dessus, et
- des moyens de détection de la variation de la magnéto-impédance du capteur de contrainte ou du microlevier agencés pour en déduire la déflection de la poutre et pour générer des signaux représentatifs de la valeur mesurée.

En fonction de la valeur mesurée, la contrainte appliquée sur le microlevier varie entrainant sa déflection et une modification de la magnéto-impédance. En effet, l'impédance d'un matériau comprenant une couche ferromagnétique extérieure est dépendante de la perméabilité relative de ladite couche ferromagnétique. Cette perméabilité relative est elle-même directement dépendante de la contrainte appliquée au matériau ferromagnétique. Ainsi, un courant à haute fréquence permet d'augmenter la valeur de l'impédance, et la mesure de cette impédance donne accès à la contrainte appliquée au matériau ferromagnétique.

Le capteur de contrainte par magnéto-impédance peut être disposé sensiblement au niveau de l'encastrement de la poutre fixée au support.

Dans une autre variante, la poutre et le capteur de contrainte sont réalisés dans le même élément de matériau magnétique de manière à former une structure monolithique, la poutre comprenant éventuellement une pointe disposée par exemple à proximité de son extrémité libre.

Dans certains modes de réalisation, le support peut être un support classiquement utilisé par exemple dans le domaine de la microscopie par sonde locale.

Dans d'autres modes de réalisation préférés, le support, la poutre, le capteur de contrainte et éventuellement la pointe de la poutre sont réalisés dans le même élément de matériau magnétique, de manière à obtenir une structure monolithique.

Les microleviers peuvent être agencés pour former une architecture en matrice unidimensionnelle ou bidimensionnelle.

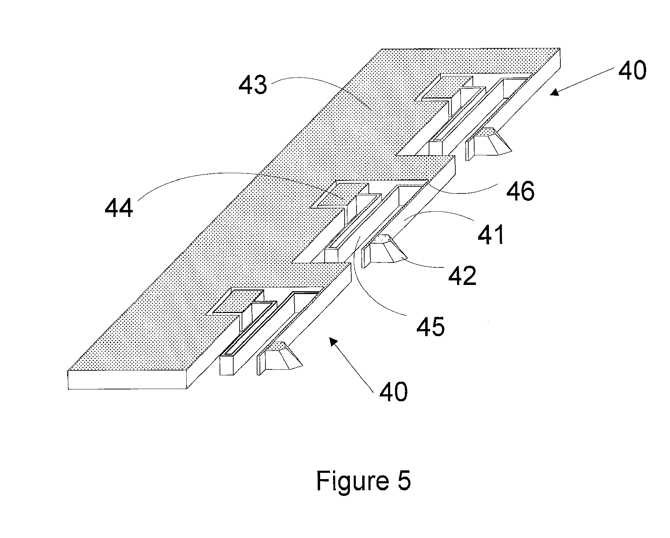

En réalisant par exemple un moule approprié, selon la deuxième variante du procédé décrit ci-dessus, on peut produire un ensemble de microleviers en matériau ferromagnétique monolithiques séparés ou en lignes (matrice à une dimension), formant un dispositif tel que celui représenté sur la figure 5. Dans cette configuration, les microleviers 40 comprenant une poutre 41 et une pointe 42 sont connectés à une ligne commune 43. La magnéto-impédance d'un microlevier 40 est mesurée entre cette ligne commune 43 et un bloc de détection 44 connecté à la poutre correspondante 41 au moyen d'un ressort 45. La connexion du ressort 45 est réalisée à proximité du point de fixation 46 de la poutre 41 de manière à provoquer le moins de perturbations possible dans le comportement mécanique du microlevier. Le ressort 45 permet de moduler les propriétés mécaniques (raideur, fréquence de résonance) du capteur en jouant sur la zone de contact avec la poutre 41, définie lors de la microfabrication du levier 40, et sur la géométrie dudit ressort 45. Les différents microleviers peuvent être séparés pour former des dispositifs comprenant une seule poutre et une seule pointe.

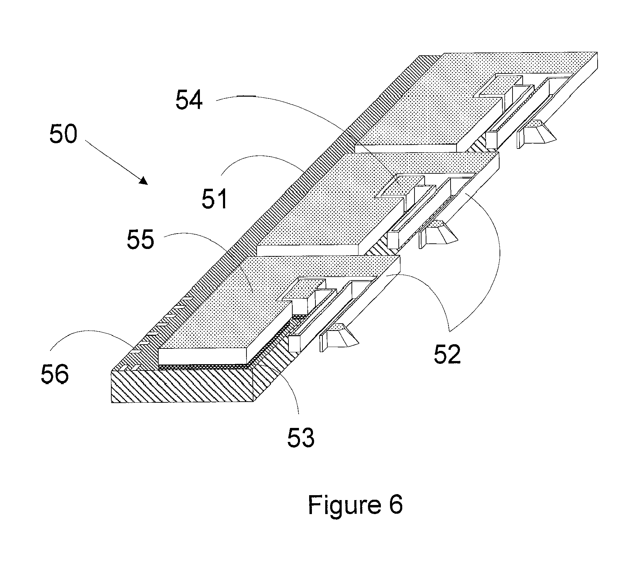

Une autre variante du dispositif selon l'invention est représentée sur la figure 6. Dans cette variante, le dispositif 50 comprend un connecteur 51 reliant plusieurs microleviers 52 et permettant d'augmenter la stabilité mécanique du système et de connecter électriquement au niveau de la zone de connexion 53 les blocs de détection 54 et les supports 55. Ce connecteur 51 comprend une interconnexion sur un ou plusieurs niveaux de manière à connecter les microleviers à l'électronique extérieure, au moyen d'éléments d'adressage 56. L'adressage électrique des capteurs de contrainte peut être multiplexé ou parallèle. Dans une autre variante non représentée, les différents supports 55 forment une seule ligne commune, similaire à la ligne commune 43 représentée figure 5.

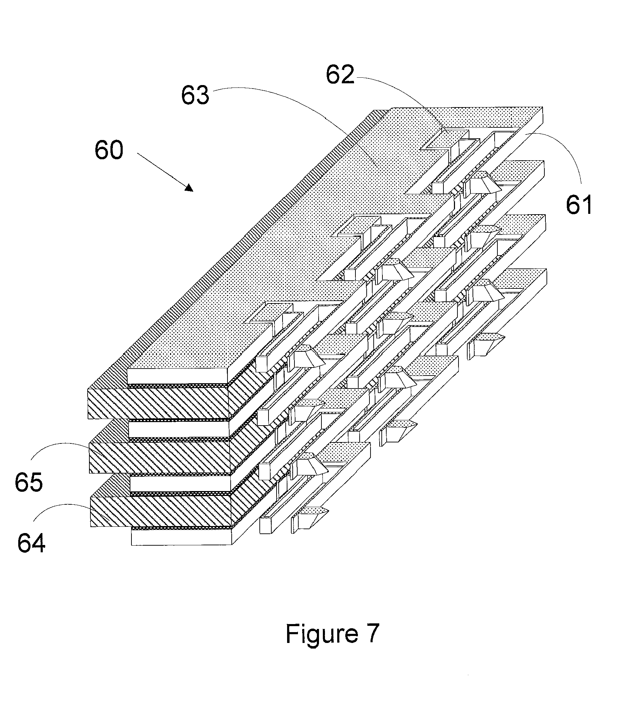

Les dispositifs de microleviers peuvent être empilés pour former une architecture en matrice bidimensionnelle, tel que cela est représenté sur la figure 7. Le dispositif 60 de la figure 7 est obtenu par les étapes suivantes:
- réalisation d'une ligne de dispositifs comprenant des microleviers 61 comprenant une poutre et une pointe, le bloc de détection 62 associé, et la ligne commune 63 en conservant le wafer de silicium (étape 7 de la deuxième variante du procédé tel que décrit ci-dessus);
- assemblage de la ligne de dispositifs à un connecteur 64 comprenant sur ses deux côtés des emplacements pour les connexions mécaniques et électriques des blocs de détection 62 et de la ligne commune 63. Le connecteur 64 est de forme appropriée de manière à permettre le libre mouvement de chaque poutre. L'assemblage est réalisé par thermocompression, soudage, colle conductrice ou en utilisant un film conducteur anisotrope;
- assemblage d'une deuxième ligne de dispositifs similaire, ayant conservé le wafer de silicium, sur l'autre face du connecteur;
- attaque des wafers de silicium en utilisant une attaque chimique humide, pour créer un empilement à deux lignes;
- assemblage de cet empilement à une des faces d'un connecteur 65;
- un autre empilement à deux lignes est assemblé sur l'autre face du connecteur 65. Le procédé d'empilement est répété jusqu'à obtenir le nombre d'éléments souhaité dans les matrices ainsi formées;
- découpage de l'empilement obtenu pour fournir des têtes de sonde séparées comprenant une matrice de microleviers à deux dimensions, telle que le dispositif 60.

Il est à noter que cet empilement peut être effectué en utilisant des lignes de microleviers isolés électriquement les uns des autres tel que représenté sur la figure 6, conduisant ainsi à la réalisation de matrice bi-dimensionnelle dont chaque levier est isolé électriquement des autres.

Les moyens de détection de la variation de la magnéto-impédance du capteur de contrainte selon l'invention peuvent être réalisés de différentes manières, connues de l'Homme du métier (cf. par exemple Mohri, K., T. Uchiyama, et al. (2002). "Amorphous wire and CMOS IC-based sensitive micro-magnetic sensors (MI sensor and SI sensor) for intelligent measurements and controls." Journal of Magnetism and Magnetic Materials 249(1-2): 351-356).

Une solution préférée consiste à choisir un système électronique basé sur des portes logiques pour exciter le capteur de contrainte par magnéto-impédance avec un courant à haute fréquence. On peut par exemple s'inspirer du circuit publié par Kanno, T., K. Mohri, et al. (1997). Amorphous wire MI Micro Sensor using C-MOS IC Multivibrator. The 1997 IEEE International Magnetics Conference (INTERMAG'97). New Orleans, Louisana, April 1-4, 1997.

La source de courant est donc une source de courant alternatif à haute fréquence (jusqu'à la dizaine de GHz comme montré par Panina LV, Sandacci SI, Makhnovskiy DP, J. Appl. Phys. 97 (1): Art. No. 013701 (2005)). Ceci permet d'utiliser les microleviers selon l'invention en microscopie de force atomique (AFM) en mode contact ou en mode dynamique (AM-AFM, FM-AFM) avec des fréquences de résonance mécanique du levier de plusieurs MHz.

Comme on l'a vu ci-dessus, la contrainte mécanique induit une modification de la réactance. La tension alternative haute fréquence prise entre les bornes du capteur contient donc l'information de cette contrainte appliquée soit sur la fréquence fondamentale du signal, soit de manière plus marquée sur ses harmoniques.

Pour analyser les signaux de réponse provenant du capteur, on peut utiliser des détecteurs de crêtes avec une technologie à diodes Schottky à temps de réponse rapide (de l'ordre de quelques nanosecondes).

De manière avantageuse, les moyens de mesure de la magnéto-impédance du capteur comprennent des moyens pour améliorer le rapport signal sur bruit. Il est par exemple possible de remplacer les détecteurs de crêtes par une démodulation synchrone. Il existe de nombreuses publications proposant différentes solutions pour réaliser cette démodulation synchrone. On peut se référer par exemple à la publication Cai, C. A., K. Usami, et al. (2004). "Frequency-modulation-type MI sensor using amorphous wire and CMOS inverter multivibrator." IEEE Transactions on Magnetics 40(1): 161-163.

La démodulation synchrone pour améliorer le rapport signal sur bruit peut également être réalisée au moyen d'une boucle à verrouillage de phase (PLL, acronyme anglais d'usage) agencée pour analyser le fondamental ou des harmoniques supérieures du signal de réponse du capteur sur une bande passante très étroite.

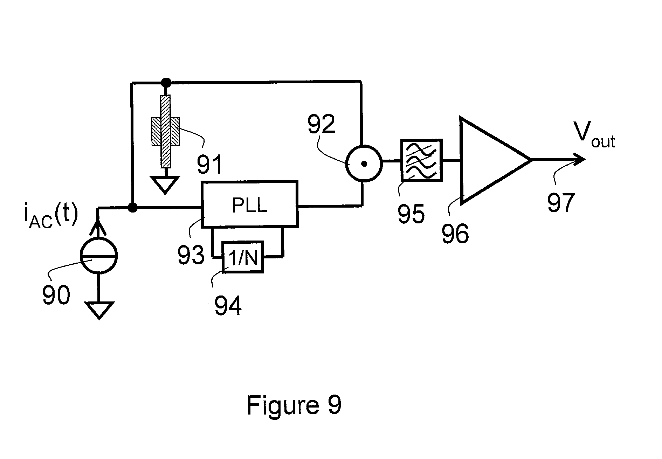

Un circuit comprenant une telle boucle à verrouillage est représenté sur la figure 9. La source de courant 90 excite le capteur par magnéto-impédance 91 à une fréquence suffisamment élevée pour obtenir un effet de peau lié au phénomène de magnéto-impédance. Le signal de réponse du capteur 91 est multiplié en 92 par le signal de référence provenant de la boucle à verrouillage de phase 93. Celle-ci analyse la fréquence du courant d'excitation de la source 90. Un diviseur de fréquence 94 permet d'obtenir un signal de sortie de la boucle à verrouillage 93 à différentes fréquences multiples de la fréquence du courant d'excitation de la source 90. Ainsi, cela permet d'analyser le signal de réponse du capteur de contrainte par magnéto-impédance 91 à différentes harmoniques pour améliorer la sensibilité de détection du système. La partie à basse fréquence du signal multiplié est ensuite extraite par un filtre passe-bas 95 et multiplié par un gain 96 pour obtenir une tension de sortie 97 Vaut proportionnelle à la contrainte appliquée sur le capteur.

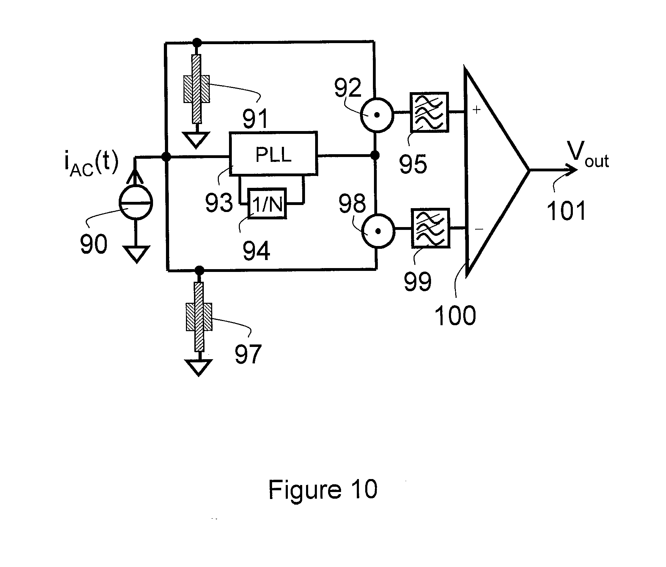

Ce circuit peut être amélioré pour annuler la dérive thermique ou d'autres perturbations électriques, en utilisant une mesure en différentiel. Pour cela, le dispositif comprend en outre un capteur de référence non soumis à la contrainte appliquée sur le microlevier, les moyens pour améliorer le rapport signal sur bruit étant alors agencés pour effectuer ladite mesure en différentiel. Un tel circuit est représenté sur la figure 10. Le capteur de référence 97 est similaire au capteur de contrainte 91 mais il est protégé de la contrainte appliquée sur le capteur de contrainte 91. Le signal de réponse du capteur de référence 97 est multiplié en 98, passe par un filtre passe-bas 99 pour être soustrait du signal du capteur de contrainte 91 par un amplificateur différentiel 100. Ensuite, le signal de sortie 101 Vₒᵤₜ est épuré des perturbations externes subies simultanément par le capteur de contrainte 91 et par le capteur de référence 97, telles que les bruits liés à la dérive thermique, aux perturbations électromagnétiques externes et éventuellement aux bruits mécaniques de la structure de maintien du réseau de microleviers.

De manière avantageuse, plusieurs microleviers peuvent être agencés pour former une architecture en matrice unidimensionnelle ou bidimensionnelle, un capteur de référence étant disposé à l'intérieur de la matrice de manière à être isolé de l'environnement extérieur des microleviers.

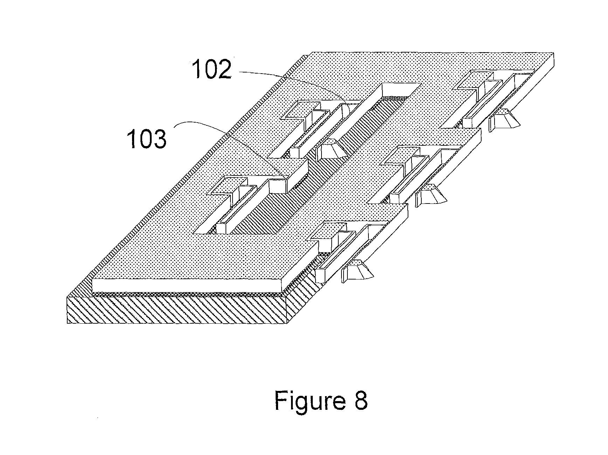

Plus particulièrement, la figure 8 représente un dispositif comprenant plusieurs microleviers agencés pour former une architecture en matrice bidimensionnelle, le capteur de référence étant disposé à l'intérieur. Pour cela les éléments de référence, qui peuvent être composés d'un microlevier 102 avec ou sans pointe, ou seulement d'une boucle de magnéto-impédance 103, sont inclus à la matrice de microleviers au moment de sa fabrication, entre deux connecteurs. Une mesure en différentiel peut être réalisée entre la matrice de microleviers et les éléments de référence. Dans cette configuration, il est possible de réaliser des mesures chimiques fines.

Par ailleurs, le rapport signal sur bruit peut être amélioré lors de la fabrication du capteur de contrainte par magnéto-impédance. Par exemple, il est possible de réaliser un recuit rapide par effet Joule en passant un courant continu à grand ampérage sur un laps de temps bref à l'intérieur du capteur par magnéto-impédance. Un tel traitement permet d'améliorer la structure cristalline de la couche ferromagnétique et ainsi d'augmenter la sensibilité de la détection par magnéto-impédance de 74%, comme montré par Li XP, Zhao ZJ, Chua C, et al. JOURNAL OF APPLIED PHYSICS 94 (12): 7626-7630 (2003).

Lorsque le microlevier comprend une pointe, le microlevier, l'ensemble de microleviers ou son dispositif correspondant est utilisé pour réaliser des microscopies par sonde locale, de type mesure de force atomique (AFM), mesure de courant tunnel (STM) ou mesure de champ évanescent optique (SNOM), par exemple dans des applications en métrologie (inspection de wafer), ou en biologie (imagerie en milieu liquide, spectroscopie de force).

Lorsque le microlevier ne comprend pas de pointe, le microlevier, l'ensemble de microleviers, ou son dispositif correspondant est utilisé pour réaliser des détecteurs chimiques, des capteurs d'humidité, de température ou pour une utilisation en spectroscopie de force (applications biologiques, chimiques, etc.). Ces applications peuvent faire appel à une fonctionnalisation chimique du levier afin de garantir une sélectivité physico-chimique.

## Revendications

1. Microlevier comprenant une poutre présentant une extrémité destinée à être fixée à un support et une autre extrémité libre, un capteur de contrainte par magnéto-impédance associé à ladite poutre, la déflection de l'extrémité libre de la poutre modifiant la magnéto-impédance du capteur, et des moyens de connexion dudit capteur de contrainte à une source de courant à haute fréquence et à des moyens de détection de la variation de la magnéto-impédance du capteur agencés pour en déduire la déflection de la poutre, **caractérisé en ce que** la poutre et le capteur de contrainte sont réalisés dans le même élément de matériau magnétique de manière à former une structure monolithique.

2. Microlevier selon la revendication 1, **caractérisé en ce que** le support est intégré au microlevier et est réalisé dans le même élément de matériau magnétique que la poutre et le capteur de contrainte de manière à former une structure monolithique.

3. Microlevier selon l'une quelconque des revendications précédentes, **caractérisé en ce que** le matériau magnétique est un matériau ferromagnétique possédant des propriétés magnétiques telles que le champ coercitif est inférieur à 2 Oe et que la perméabilité magnétique relative est supérieure à 1000.

4. Microlevier selon la revendication 3, **caractérisé en ce que** ledit matériau est un alliage métallique.

5. Microlevier selon la revendication 4, **caractérisé en ce que** ledit alliage métallique est un alliage à base de nickel et de fer, la concentration en fer étant comprise entre 10% et 60% en poids par rapport au poids total du l'alliage.

6. Microlevier selon l'une quelconque des revendications précédentes, **caractérisé en ce que** la poutre comprend une pointe pour microscopie par sonde locale, ladite pointe étant réalisée dans le même élément de matériau magnétique que la poutre de manière à former une structure monolithique.

7. Ensemble de microleviers comprenant un support et au moins deux microleviers selon l'une quelconque des revendications 1 à 6, une extrémité de la poutre de chacun des microleviers étant fixée audit support, dans lequel le support est réalisé dans le même élément de matériau magnétique que la poutre et le capteur de contrainte de manière à former une structure monolithique.

8. Dispositif de mesure d'une valeur par détection de déflection d'un microlevier soumis à une contrainte, **caractérisé en ce qu'**il comprend:
- un support,
- une source de courant à haute fréquence,
- au moins un microlevier comprenant une poutre, présentant une extrémité destinée à être fixée audit support et une autre extrémité libre, et un capteur de contrainte par magnéto-impédance associé à ladite poutre, la déflection de l'extrémité libre de la poutre modifiant la magnéto-impédance du capteur, des moyens de connexion dudit capteur de contrainte à ladite source de courant, et
- des moyens de détection de la variation de la magnéto-impédance du capteur agencés pour en déduire la déflection de la poutre et pour générer des signaux représentatifs de la valeur mesurée.

9. Dispositif selon la revendication 8, **caractérisé en ce que** ledit capteur de contrainte est disposé sensiblement au niveau de l'encastrement de la poutre fixée au support.

10. Dispositif selon la revendication 8, **caractérisé en ce que** la poutre et le capteur de contrainte sont réalisés dans le même élément de matériau magnétique de manière à former une structure monolithique.

11. Dispositif selon la revendication 8, **caractérisé en ce que** la poutre, le capteur de contrainte et le support sont réalisés dans le même élément de matériau magnétique de manière à former une structure monolithique.

12. Dispositif selon l'une quelconque des revendications 8 à 11, **caractérisé en ce que** le capteur de contrainte est réalisé dans un matériau ferromagnétique possédant des propriétés magnétiques telles que le champ coercitif est inférieur à 2 Oe et que la perméabilité magnétique relative est supérieure à 1000.

13. Dispositif selon l'une quelconque des revendications 8 à 12, **caractérisé en ce que** les moyens de mesure de la magnéto-impédance du capteur comprennent des moyens pour améliorer le rapport signal sur bruit.

14. Dispositif selon la revendication 13, **caractérisé en ce que** les moyens pour améliorer le rapport signal sur bruit comprennent une boucle à verrouillage de phase agencée pour analyser le fondamental ou des harmoniques supérieures du signal de réponse du capteur sur une bande passante très étroite.

15. Dispositif selon la revendication 14, **caractérisé en ce qu'**il comprend en outre un capteur de référence non soumis à la contrainte appliquée sur le microlevier, et **en ce que** les moyens pour améliorer le rapport signal sur bruit sont agencés pour effectuer une mesure en différentiel.

16. Dispositif selon l'une quelconque des revendications 8 à 15, **caractérisé en ce qu'**il comprend plusieurs microleviers agencés pour former une architecture en matrice unidimensionnelle ou bidimensionnelle.

17. Dispositif selon les revendications 15 et 16, **caractérisé en ce que** ledit capteur de référence est disposé à l'intérieur de la matrice de manière à être isolé de l'environnement extérieur des microleviers.

18. Dispositif selon l'une quelconque des revendications 8 à 17, **caractérisé en ce que** la poutre comprend une pointe pour microscopie par sonde locale, disposée à proximité de l'extrémité libre de la poutre.

19. Procédé de fabrication d'un microlevier selon l'une quelconque des revendications 1 à 6, **caractérisé en ce qu'**il comprend une étape de réalisation d'un moule comprenant au moins un fond en matériau monocristallin permettant une attaque anisotrope selon ses plans cristallins et une étape de formation du microlevier par électrodéposition d'un matériau magnétique doux dans le moule.

20. Procédé selon la revendication 19, **caractérisé en ce que** l'électrodéposition est réalisée sous champ magnétique externe contrôlé afin d'orienter magnétiquement le matériau magnétique doux.

21. Utilisation d'un microlevier selon l'une quelconque des revendications 1 à 5 ou d'un ensemble de microleviers selon la revendication 7, ou d'un dispositif selon l'une quelconque des revendications 8 à 17 pour la réalisation de détecteurs chimiques, de température ou d'humidité.

22. Utilisation d'un microlevier selon la revendication 6 ou d'un ensemble de microleviers selon la revendication 7, ou d'un dispositif selon la revendication 18 pour réaliser de la microscopie par sonde locale.

23. Procédé de mesure d'une valeur par détection de la déflection d'un microlevier soumis à une contrainte, ledit microlevier comprenant une poutre et un capteur de contrainte par magnéto-impédance associé à ladite poutre, en particulier au moyen d'un dispositif selon l'une quelconque des revendications 8 à 18, comprenant une étape de mesure de la modification de la magnéto-impédance dudit capteur de contrainte lorsqu'il est soumis à un courant à haute fréquence.

24. Procédé selon la revendication 23, dans lequel la mesure de la modification de la magnéto-impédance du capteur de contrainte consiste à mesurer la réactance dudit capteur de contrainte.
